# EUROPÄISCHE PATENTANMELDUNG

(11) **EP 2 211 384 A2**
(43) Veröffentlichungstag der Anmeldung: **28.07.2010**
(21) Anmeldenummer: 09015175.4
(22) Anmeldetag: 08.12.2009
(51) Int. Cl.: H01L 23/48, H01L 25/07

(54) **Leistungshalbleitermodul in Druckkontaktausführung mit aktiver Kühleinrichtung**

(30) Priorität: 23.01.2009 DE 102009005915
(71) Anmelder: SEMIKRON Elektronik GmbH & Co. KG, 90431 Nürnberg (DE)
(72) Erfinder: Beckedahl, Peter, 90522 Oberasbach (DE); Knebel, Markus, 90587 Tuchenbach (DE)

(57) **Zusammenfassung**

Es wird ein Leistungshalbleitermodul (10) in Druckkontaktausführung beschrieben, das zur Anordnung an einem Kühlbauteil (12) vorgesehen ist. Das Leistungshalbleitermodul (10) weist mindestens ein Substrat (14) auf, an dem Leistungshalbleiterbauelemente (20) angeordnet sind. Eine Druckeinrichtung (26) dient zur Druckkontaktierung der Leistungshalbleiterbauelemente (20) an dem mindestens einen Substrat (14).
Wärmeabteilung von dem Substrat (14) erfolgt über das Kühlbauteil (12) und über die Druckeinrichtung (26), die als aktive Kühleinrichtung (28) ausgebildet ist.

## Beschreibung

Die Erfindung betrifft ein Leistungshalbleitermodul in Druckkontaktausführung zur Anordnung an einem Kühlbauteil, mit mindestens einem Substrat, auf dem Leistungshalbleiterbauelemente angeordnet sind, und mit einer Druckeinrichtung zur Druckkontaktierung der Leistungshalbleiterbauelemente an dem mindestens einen Substrat und zur Wärme ableitenden Anordnung des mindestens einen Substrates an dem Kühlbauteil.

Derartige Leistungshalbleitermodule sind in verschiedenen Ausbildungen an sich bekannt. Beispielsweise beschreibt die DE 101 21 970 B4 ein Leistungshalbleitermodul in Druckkontaktausführung. Dieses bekannte Leistungshalbleitermodul besteht aus einem Gehäuse, einem keramischen Substrat, schaltungsgerecht darauf vorgesehenen strukturierten und elektrisch leitenden Kontaktflächen, darauf angeordneten Bauelementen, mindestens einer die Bauelemente elektrisch verbindenden flexiblen Leiterplatte, einer Druckeinrichtung bestehend aus einem flexiblen Speicher und einer den Druck erzeugenden Druckplatte, und Leistungs- und Steueranschlüssen, wobei zur Isolation der Bauelemente gegeneinander ein flexibler Isolationsstoff vorgesehen ist, und die Kontaktierung der flexiblen Leiterplatte mit den Bauelementen und/oder mit den Kontaktflächen des Substrates durch warzenartige Erhebungen derart gebildet wird, dass bei einer Druckbeaufschlagung mittels der Druckeinrichtung eine sichere elektrisch leitende Verbindung gebildet wird. Bei den Bauelementen des Leistungshalbleitermoduls kann es sich um Leistungsdioden, Leistungsthyristoren, Leistungstransistoren oder dergleichen handeln.

Ein Leistungshalbleitermodul in Druckkontaktausführung ist beispielsweise auch aus der DE 10 2006 006 425 A1 bekannt, das zur Anordnung auf einem Kühlbauteil vorgesehen ist.

Bei den bekannten Leistungshalbleitermodulen dient die Druckeinrichtung dazu, Druck auf das mindestens eine Substrat und/oder auf die Leistungshalbleiterbauelemente auszuüben. Für eine Wärmeableitung ist die Druckeinrichtung der bekannten Leistungshalbleitermodule nicht vorgesehen sondern nur das Kühlbauteil, an welchem das mindestens eine Substrat des Leistungshalbleitermoduls angeordnet ist.

Der Erfindung liegt die Aufgabe zugrunde, ein Leistungshalbleitermodul der eingangs genannten Art zu schaffen, bei welchem das Kühlkonzept für die Leistungshalbleiterbauelemente verbessert ist.

Diese Aufgabe wird erfindungsgemäß durch die Merkmale des Anspruches 1, d.h. dadurch gelöst, dass die Druckeinrichtung als aktive Kühleinrichtung ausgebildet ist.

Bei dem erfindungsgemäßen Leistungshalbleitermodul dient also nicht nur das Kühlbauteil auf der einen Seite des mindestens einen Substrates sondern außerdem auch die Druckeinrichtung auf der vom Kühlbauteil abgewandten Seite des Leistungshalbleitermoduls als ein Wärme ableitendes Element, so dass das erfindungsgemäße Leistungshalbleitermodul mit einer vergleichsweise großen Leistung betrieben werden kann. Ein weiterer Vorteil besteht darin, dass infolge der Verbesserung der Kühlung auch die Lebensdauer des erfindungsgemäßen Leistungshalbleitermoduls verlängert ist. Gegebenenfalls sind mit dem erfindungsgemäßen Leistungshalbleitermodul auch die Einbaumöglichkeiten günstiger, weil der Einbauraum für das erfindungsgemäße Leistungshalbleitermodul kleiner sein kann, weil das Kühlbauteil kleinervolumig ausgebildet sein kann.

Bei dem erfindungsgemäßen Leistungshalbleitermodul kann die aktive Kühleinrichtung der Druckeinrichtung von einem Kühlmedium durchflossen sein. Bei dem Kühlmedium der aktiven Kühleinrichtung der Druckeinrichtung kann es sich um eine Kühlflüssigkeit handeln. Bei dieser Kühlflüssigkeit kann es sich zum Beispiel um ein Gemisch aus Wasser und Glykol handeln.

Desgleichen ist es möglich, dass die aktive Kühleinrichtung der Druckeinrichtung eine Heatpipe aufweist, wie sie beispielsweise in Laptops und PCs zur Anwendung gelangt.

Bei dem erfindungsgemäßen Leistungshalbleitermodul kann die aktive Kühleinrichtung der Druckeinrichtung zur Druckkontaktierung von Kontaktelementen an den Leistungshalbleiterbauelementen und/oder an einer Schaltungsstruktur des mindestens einen Substrates und/oder zur Druckkontaktierung von Lastanschlusselementen mit der Schaltungsstruktur des mindestens einen Substrates vorgesehen sein. Dabei können die Kontaktelemente an einer flexiblen Leiterplatte - ähnlich wie in der eingangs zitierten DE 101 21 970 B4 beschrieben - vorgesehen sein. Die Lastanschlusselemente können jeweils einen zu dem mindestens einen Substrat parallelen bandartigen Abschnitt aufweisen, von dem ein Kontaktfuß - wie in der ebenfalls eingangs zitierten DE 10 2006 006 425 A1 beschrieben worden ist -wegsteht. Die Anschlusselemente sind derartig vorgesehen, dass die Kontaktfüße der Anschlusselemente alle in die gleiche Richtung wegstehen.

Die aktive Kühleinrichtung der Druckeinrichtung des erfindungsgemäßen Leistungshalbleitermoduls kann ein Brückenelement bilden, das mit einer Druckplatte und einem elastischen Druckspeicher kombiniert ist, wobei die Druckplatte mit dem Kühlbauteil mechanisch verspannt ist.

Unabhängig von der jeweiligen speziellen Ausbildung weist das erfindungsgemäße Leistungshalbleitermodul die Vorteile einer zweiseitigen und somit verbesserten Kühlung auf, so dass die Leistungshalbleiterbauelemente mit einer höheren Leistung betrieben werden können, wobei dieser Vorteil mit dem Vorteil einer vergleichsweise langen Lebensdauer der Leistungshalbleiterbauelemente einhergeht.

Weitere Einzelheiten, Merkmale und Vorteile ergeben sich aus der nachfolgenden Beschreibung von in der Zeichnung schematisch dargestellten Ausführungsbeispielen des erfindungsgemäßen Leistungshalbleitermoduls, wobei es sich versteht, dass die Erfindung nicht auf die schematisch gezeichneten Ausführungsformen beschränkt, sondern durch die Ansprüche bestimmt ist.

### Es zeigen:

- Figur 1: in einer schematischen Schnittdarstellung eine erste Ausführungsform des Leistungshalbleitermoduls,
- Figur 2: in einer der Figur 1 ähnlichen schematischen Schnittdarstellung eine zweite Ausführungsform des Leistungshalbleitermoduls, und
- Figur 3: in einer den Figuren 1 und 2 ähnlichen schematischen Schnittdarstellung eine dritte Ausführungsform des Leistungshalbleitermoduls.

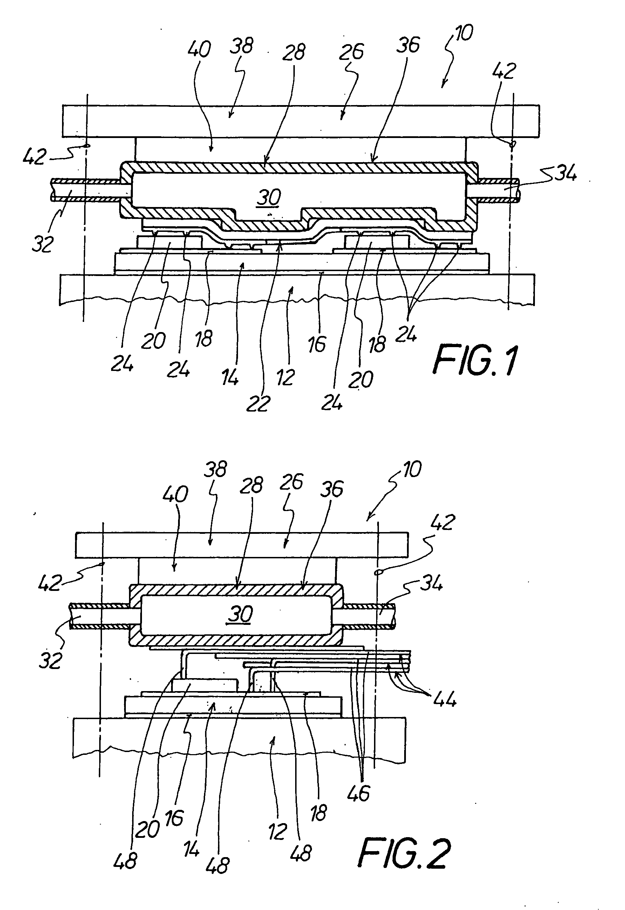

Figur 1 zeigt eine Ausführungsform des Leistungshalbleitermoduls in Druckkontaktausführung, das zur Anordnung an einem abschnittweise gezeichneten Kühlbauteil 12 vorgesehen ist. Das Leistungshalbleitermodul 10 weist ein Substrat 14 auf, bei dem es sich um eine DCB (Direct Copper Bonding) handelt. Das Substrat 14 weist einseitig großflächig eine Metalllage 16 auf. An der gegenüberliegenden anderen Seite des Substrates 14 ist eine strukturierte Metalllage, d.h. eine Schaltungsstruktur 18, vorgesehen. Auf der Schaltungsstruktur 18 sind Leistungshalbleiterbauelemente 20 vorgesehen. Zur Kontaktierung der Leistungshalbleiterbauelemente 20 mit der Schaltungsstruktur 18 ist eine flexible Leiterplatte 22 vorgesehen, die Kontaktnoppen 24 aufweist. Die flexible Leiterplatte 22 wird mit Hilfe einer Druckeinrichtung 26 gegen die Leistungshalbleiterbauelemente 20 und gegen die Schaltungsstruktur 18 des Substrates 14 gedrückt, um eine Druckkontaktierung der Leistungshalbleiterbauelemente 20 an dem Substrat 14 zu bewirken. Die Druckeinrichtung 26 dient gleichzeitig zur Wärme ableitenden Anordnung des Substrates 14 an dem Kühlbauteil 12.

Die Druckeinrichtung 26 ist als aktive Kühleinrichtung 28 ausgebildet. Zu diesem Zwecke ist die aktive Kühleinrichtung 28 mit einem Hohlraum 30 ausgebildet, in welchen eine Zuleitung 32 einmündet und aus welchem eine Rohrleitung 34 ausmündet. Durch die Zuleitung 32 wird in den Hohlraum 30 ein Kühlmedium eingeleitet, bei dem es sich um eine Kühlflüssigkeit handelt.

Die Verlustwärme der Leistungshalbleiterbauelemente 20 wird also nicht nur an das Kühlbauteil 12 sondern außerdem auch an die aktive Kühleinrichtung 28 abgegeben, d.h. die im Hohlraum 30 befindliche Kühlflüssigkeit wird erwärmt und die erwärmte Kühlflüssigkeit durch die Rohrleitung 34 aus der aktiven Kühleinrichtung 28 ausgeleitet. Gleichzeitig wird frische Kühlflüssigkeit durch die Zuleitung 32 der aktiven Kühleinrichtung 28 zugeführt.

Die eine aktive Kühleinrichtung 28 bildende Druckeinrichtung 26 bildet ein Brückenelement 36, das mit einer Druckplatte 38 und einem elastischen Druckspeicher 40 ausgebildet ist, wobei der elastische Druckspeicher 40 zwischen der Druckplatte 38 und der aktiven Kühleinrichtung 28 angeordnet und die Druckplatte 38 mit dem Kühlbauteil 12 mechanisch verspannt ist. Diese mechanische Verspannung ist durch dünne strichpunktierte Linien 42 schematisch angedeutet.

Figur 2 zeigt eine Ausführungsform des Leistungshalbleitermoduls 10, das sich von dem in Figur 1 gezeichneten Ausführungsbeispiel dadurch unterscheidet, dass Lastanschlusselemente 44 dargestellt sind, die jeweils einen zum Substrat 14 parallelen bandartigen Abschnitt 46 und einen von diesem weg stehenden Kontaktfuß 48 aufweisen. Die bandartigen Abschnitte 46 sind gegeneinander und gegen die eine aktive Kühleinrichtung 28 bildende Druckeinrichtung 26 elektrisch isoliert.

Gleiche Einzelheiten sind in Figur 2 mit denselben Bezugsziffern wie in Figur 1 bezeichnet, so dass es sich erübrigt, in Verbindung mit Figur 2 alle Einzelheiten noch einmal detailliert zu beschreiben.

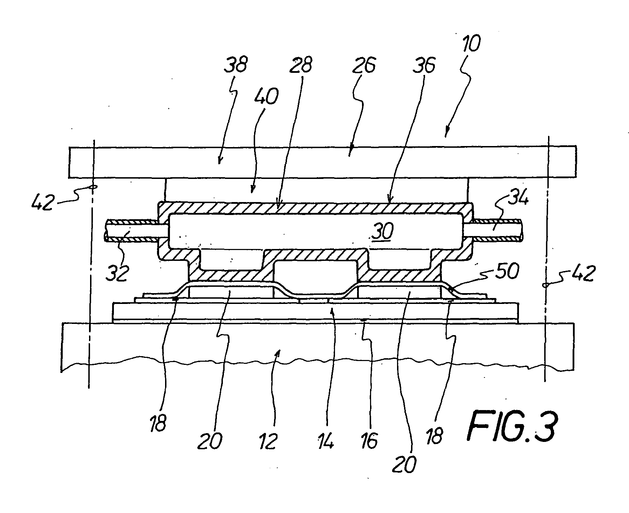

Figur 3 zeigt in einer den Figuren 1 und 2 ähnlichen schematischen Darstellung eine Ausbildung des Leistungshalbleitermoduls 10 in Druckkontaktausführung zur Anordnung an einem Kühlbauteil 12. Mit dem Kühlbauteil 12 ist eine Druckeinrichtung 26 mechanisch verspannt, die eine Druckplatte 38, einen elastischen Druckspeicher 40 und ein Brückenelement 36 mit einem Hohlraum 30 aufweist. Das Brückenelement 36 bildet eine aktive Kühleinrichtung 28, die z.B. auf Lastanschlusselemente und über diese auf Leistungshalbleiterbauelemente 20 drückt. Zwischen dem Brückenelement 36 und den Leistungshalbleiterelementen 20 ist eine Isolationslage 50 vorgesehen, wie sie beispielsweise in der DE 10 2005 053 400 A1 beschrieben ist.

Gleiche Einzelheiten sind auch in Figur 3 mit denselben Bezugsziffern wie in den Figuren 1 und 2 bezeichnet, so dass es sich erübrigt, in Verbindung mit Figur 3 alle Einzelheiten noch einmal detailliert zu beschreiben.

### Bezugsziffernliste:

- 10: Leistungshalbleitermodul
- 12: Kühlbauteil (für 10)
- 14: Substrat (von 10)
- 16: Metalllage (an 14)
- 18: Schaltungsstruktur (an 14 für 20)
- 20: Leistungshalbleiterbauelement
- 22: flexible Leiterplatte (von 10)
- 24: Kontaktnoppen (von 22)
- 26: Druckeinrichtung (von 10)
- 28: aktive Kühleinrichtung (von 26)
- 30: Hohlraum (in 28)
- 33: Zuleitung (für 30)
- 34: Rohrleitung (für 30)
- 36: Brückenelement (von 10 für 26)
- 38: Druckplatte (von 26)
- 40: elastischer Druckspeicher (von 26)
- 42: strichpunktierte Linie / mechanische Verspannung (zwischen 38 und 12)
- 44: Lastanschlusselemente (von 10)
- 46: bandartige Abschnitt (von 44)
- 48: Kontaktfüße (von 44)
- 50: Isolationslage (zwischen 36 und 20)

## Patentansprüche

1. Leistungshalbleitermodul in Druckkontaktausführung, zur Anordnung an einem Kühlbauteil (12), mit mindestens einem Substrat (14), an dem Leistungshalbleiterbauelemente (20) angeordnet sind, und mit einer Druckeinrichtung (26) zur Druckkontaktierung der Leistungshalbleiterbauelemente (20) an dem mindestens einen Substrat (14) und zur Wärme ableitenden Anordnung des mindestens einen Substrates (14) an dem Kühlbauteil(12),
**dadurch gekennzeichnet,**
**dass** die Druckeinrichtung (26) als aktive Kühleinrichtung (28) ausgebildet ist.

2. Leistungshalbleitermodul nach Anspruch 1,
**dadurch gekennzeichnet,**
**dass** die aktive Kühleinrichtung (28) der Druckeinrichtung (26) von einem Kühlmedium durchflossen ist.

3. Leistungshalbleitermodul nach Anspruch 2,
**dadurch gekennzeichnet,**
**dass** das Kühlmedium der aktiven Kühleinrichtung (28) von einer Kühlflüssigkeit gebildet ist.

4. Leistungshalbleitermodul nach einem der Ansprüche 1 bis 3,
**dadurch gekennzeichnet,**
**dass** die aktive Kühleinrichtung (28) der Druckeinrichtung (26) eine aktive Luftkühlung aufweist.

5. Leistungshalbleitermodul nach Anspruch 1 oder 2,
**dadurch gekennzeichnet,**
**dass** die aktive Kühleinrichtung (28) der Druckeinrichtung (26) eine Heatpipe aufweist.

6. Leistungshalbleitermodul nach einem der Ansprüche 1 bis 5,
**dadurch gekennzeichnet,**
**dass** die aktive Kühleinrichtung (28) der Druckeinrichtung (26) zur Druckkontaktierung von Kontaktelementen (24) an den Leistungshalbleiterbauelementen (20) und an der Schaltungsstruktur (18) des mindestens einen Substrates (14) und/oder zur Druckkontaktierung von Lastanschlusselementen (44) mit der Schaltungsstruktur (18) des mindestens einen Substrates (14) vorgesehen ist.

7. Leistungshalbleitermodul nach Anspruch 6,
**dadurch gekennzeichnet,**
**dass** die Kontaktelemente (24) an einer flexiblen Leiterplatte (22) vorgesehen sind.

8. Leistungshalbleitermodul nach Anspruch 6,
**dadurch gekennzeichnet,**
**dass** die Lastanschlusselemente (44) jeweils einen zum mindestens einen Substrat (14) parallelen bandartigen Abschnitt (46) aufweisen, von dem ein Kontaktfuß (48) wegsteht.

9. Leistungshalbleitermodul nach einem der Ansprüche 1 bis 8,
**dadurch gekennzeichnet,**
**dass** die aktive Kühleinrichtung (28) der Druckeinrichtung (26) ein Brückenelement (36) bildet, das mit einer Druckplatte (38) und einem elastischen Druckspeicher (40) kombiniert ist, wobei die Druckplatte (38) mit dem Kühlbauteil (12) mechanisch verspannt ist.
